# EUROPEAN PATENT APPLICATION

(11) **EP 0 639 003 A1**
(43) Date of publication of application: **15.02.1995**
(21) Application number: 94305468.4
(22) Date of filing: 25.07.1994
(51) Int. Cl.: H03K 5/13

(54) **Digitally adjustable and calibrated delay line and method**

(30) Priority: 11.08.1993 US 105529
(71) Applicant: ADVANCED MICRO DEVICES INC., Sunnyvale, California 94088-3453 (US)
(72) Inventor: Behrim, Michael N., Livermore, California 94550 (US)
(74) Representative: Wright, Hugh Ronald

(57) **Abstract**

A CMOS delay line and method for adjusting and calibrating propagation characteristics of the delay line. The delay line includes an array of cells connected in series with terminals spaced along the line for detecting the time that the transition edges of a propagating signal appear can be detected relative to the time of appearance of said transition edge of the input signal. Each cell of the delay line includes a CMOS transistor pair with both gates connected to an input terminal of the cell and both drains connected to an output terminal of the cell. The source terminals of the PMOS transistor and the NMOS transistor are each connected to biasing potential through a digitally controllable load. The load is another array of PMOS and NMOS transistors which add resistances and capacitance in parallel and therefore control propagation characteristic of the cell. The load is adjustable by applying logic signals on selected gates to the series array. A preferred method of calibration is to begin with all switches (logic gates) between bias potential and gates open so as to maximize delay, then open switches successively to move the transition edge of the propagated signal. An embodiment of the invention accomplishes this shift in two modes, a coarse mode which is the initial mode and a fine mode.

## Description

This invention relates to a delay line and particularly to a method and apparatus for adjusting the propagation characteristic of the line to control the phase of the output signal relative to the phase of the input signal.

A fundamental requirement for communication in a pulse encoded data system is to time the arrival of leading and falling edges of transmitted data pulses arriving at the receiving station (the received pulses) to coincide with edges from pulses of a signal local to the receiver. Systems to which this requirement applies include a host computer and a peripheral and one computer communicating with another.

Traditionally, phase locked loops using analog and digital techniques have been the method of choice for recovering serially transmitted data The technique involves comparing the phases of the data bit and local oscillator pulse to produce a signal that controls the frequency of a voltage controlled oscillator. Digital techniques are now replacing this analog approach and digitally controlled delay lines are needed to assist in performing these functions.

An approach is described in IBM Technical Disclosure Bulletin v. 28, No. 7, Dec. 1985 according to which a time delay circuit for digital MFM data separation uses an extra clock pulse to charge a capacitor for the duration of a clock pulse after which, arrival of a data pulse initiates discharge of the capacitor to generate a delay signal having the same duration as the clock signal.

More recently, delay circuits using CMOS technology have been disclosed which suggest an alternate method for performing these delay functions. None of the cited art known to me provides the fine incremental adjustment of delay that is provided by the present invention. The large size and expense of inductors used in normal delay lines present difficulties in combining that technology with digital circuits. The increased speed and reliability of CMOS circuits has stimulated interest in applying CMOS technology to delay line applications. However due to processing problems, it is impossible to design a CMOS delay line which will operate for all temperatures and voltages expected while maintaining the close tolerances on delay specification.

We will describe a calibrateable delay line involving techniques that are primarily digital and easy to process using CMOS technology. It is therefore contemplated that these techniques be especially convenient for integration into digital VLSI design.

We will describe a delay line such that the leading or falling edges of pulses input to the delay can be provided at a later time that is adjustable and accurately controlled. In accordance with this it is further contemplated to provide a method for accurately and conveniently calibrating the propation delay time of the cells of the delay line .

We will describe a delay line that can be adapted for use in decoding transmitted PCM data and other applications.

We will describe a delay line used to generate clock frequencies that are a multiple of a base clock frequency.

Such a delay line may comprise identical unit delay cells connected in series. Each unit delay cell includes a "delay" PMOS/NMOS transistor pair whose propagation time is adjusted by control voltages applied to selected gates of a parallel array of "control" PMOS/NMOS transistor pairs connected as a load on the "delay" PMOS/NMOS transistor pair. The gate of each "control" transistor is connected through a switch to a bias voltage so that "control" transistors in the array can be selectively enabled by closing appropriate switches according to a digital code. The delay line can be calibrated by detecting the occurrence of signal level transitions at sample terminals along the line between the unit delay cells as they relate to the falling and leading edges of clock transitions at the input and selectively closing switches to establish the desired propagation characteristics of the delay line.

Comparing the logic levels of adjacent sample terminals is used to determine if a transition is present between the sample points at the time that the samples are taken. The number of cells between sample terminals along the delay line determines the accuracy with which the transitions are located. The density of sample terminals is greater near the end of the delay line to enable fine control of the accuracy of transition detection and reduce the calibration error of the delay call.

A delay line comprising a preferred embodiment of the invention will now be described by way of example with reference to the drawings in which:-

Fig. 1 is a schematic drawing of the delay line showing the cells connected in series.

Fig. 2 is a schematic of a single cell of Fig.1.

Fig. 3 is a subsection of the cell of Fig. 2.

Fig. 4 is a timing diagram showing an edge transition of a propagated wave relative to the initial signal.

Fig. 5 is a schematic diagram of a circuit for clock multiplication.

Fig. 6 is a schematic diagram of a circuit for edge detection for delay line calibration.

Fig. 7 is a schematic diagram showing delay selection registers.

Fig. 8 is a flow diagram of the decision process for moving the transition edge from "coarse" to output terminal of the delay line.

Fig. 9 is a flow chart illustrating operation of the algorithm state machine.

Fig. 10 is a table listing the symbols used in the flow diagram of the algorithmic state machine.

Turning now to a discussion of the preferred embodiments, the figures show preferred embodiments in which the following table lists various items shown in the figures together with the item numbers.

| | |
|---|---|
| 10-1 delay line | 26 sample terminal |
| 12-1 cells | 27 OR gate |
| 13 control section | 32 D Flipflop |
| 14 delay subsection | 33 Clock input |
| 15 delay section | 34 NAND gates |
| 16 PMOS | 36 NAND gate coarse early |
| 17 NMOS | 38 Fine early |
| 18 PMOS | 40 Base Select Register |
| 19 NMOS | 42 Increment Select Register |
| 20 Enable switch | 44 Logic Gate |
| 22 Inverter | 46 Adjust mode |
| 24 output terminal | 48 Monitor Mode |

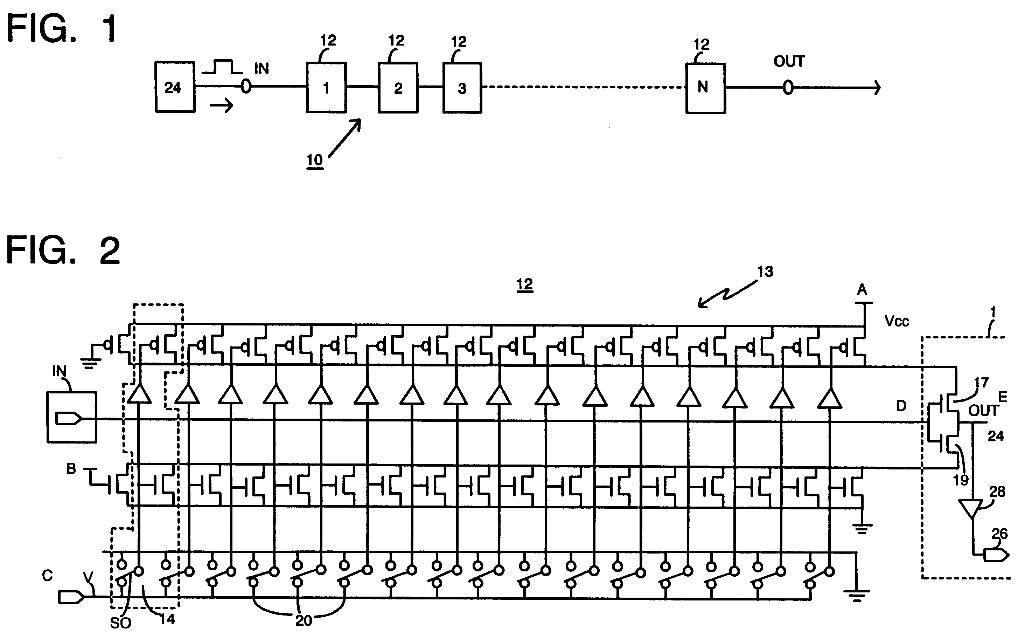

Fig. 1 is a schematic diagram of a delay line 10 composed of n delay identical cells 12 connected in series. The schematic diagram of a cell 12 is shown in Fig. 2. Each cell 12 has two sections, a delay section 15 and a control section 13.

The delay section 15 includes a PMOS/NMOS transistor pair 17, 19 whose drains are connected to a cell output terminal 24. Each cell has a terminal to sample its output. A sample buffer 28 has a sample output terminal 26 and an input terminal connected to cell output terminal 24.

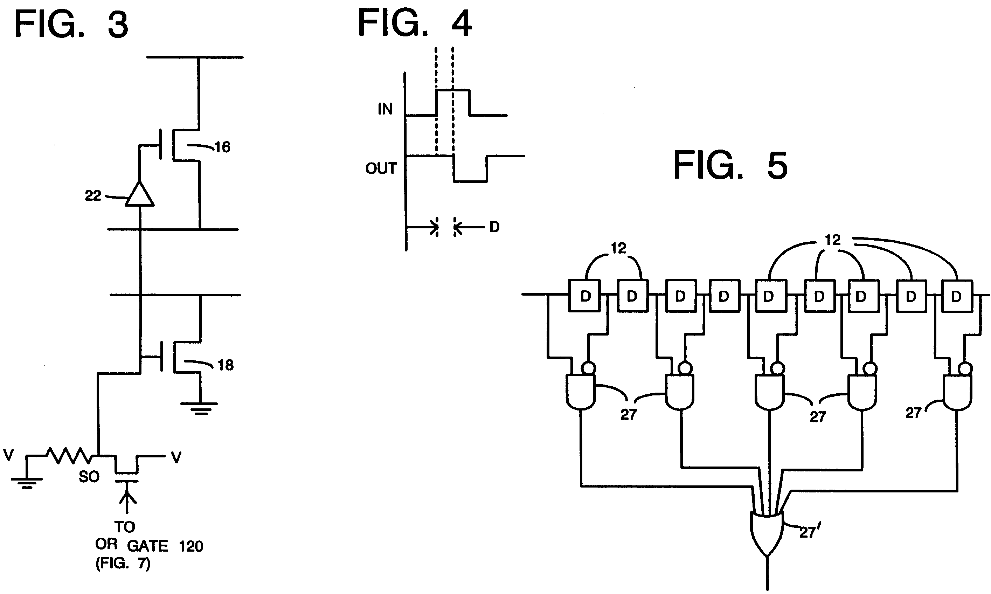

The control section 13 of cell 12 is composed of a plurality of delay subsections 14. Fig. 2 shows a delay cell 12 with seventeen subsections 14 one of which on the far left is enclosed by a dashed line. Details of a delay subsection 14 shown in Fig. 2 are shown to greater advantage in fig. 3 and include a PMOS transistor 16 paired with an NMOS transistor 18, an enable switch 20, and an inverter 22. The enabling switch 20 has one terminal connected to gate voltage V and another terminal connected to the gate of the PMOS transistor 16 and the gate of NMOS 18 through inverter 22. Therefore, selected gates of the control section 13 can be enabled in parallel by switching the respective switches from ground to apply gate voltage V to the gates of the selected subsections 14.

The drains of the control PMOS/NMOS transistors (16, 18) of all the delay subsections 14 are connected respectively to the sources of delay PMOS/NMOS pair (17,19) of delay circuit 15 . As the number of enable switches 20 of the cell are closed, (i.e., the number of selected control lines of a cell is increased) the propagation delay is decreased. If the voltages applied to all of the control lines are set to zero, the cell is "calibrated" to its intrinsic value, i.e., the propagation delay of the cell is minimum. The intrinsic value depends on such factors as Vcc, temperature and the process conditions for producing the cell. The output load of each cell depends upon the input capacitance of the identical delay cell connected to its output.

Fig. 2 shows each delay cell having a sample terminal 26 where the rising/falling edges of pulses propagating through the delay line can be compared to the initial pulse IN from signal source 24. The delay time, D, is shown in Fig. 4 as being the difference in time between transition edges of the signal IN and signal OUT at the respective sample terminal.

Each cell delay section 15 inverts the signal. Although the ratio of the dimensions of the PMOS/NMOS pair (length and width of PMOS transistor with respect to the dimensions of NMOS) are selected to balance their mobility differences, the inverting cell will have a slightly different propagation delay for a low-to-high transition at its input compared to a high to low transition, primarily as a result of variations in process conditions of manufacture. Therefore, two inverting delay cells must be connected in series to form a single non-inverting delay cell to achieve identical propagation delay regardless of the direction (rising or falling) of the input transition.

In the present embodiment, the inverting cell is designed so that it can be calibrated to 0.5 ns for all process variations and allowed VCC levels and temperatures. The cell delay is decreased by asserting more control lines, (closing switches) one by one in numerical sequence starting with S(0). (see fig. 2) until the correct delay is achieved. The largest delay will be attained with few control lines selected (i.e., most of the switches open). For smallest delay, almost all of the control lines will have been selected.

The delay line is calibrated by applying an external calibration clock signal to the input and comparing the phase of the propagated signal at various sample terminals (26 in Fig. 2) on the delay line to the input signal. The number of cells in the delay line is selected relative to the period of the calibration clock. For example, in the embodiment presented herein, a calibration clock period of 40 ns (25MHz) is used with 40 1 ns cells. To calibrate the delay line the clock signal is applied to the input to the delay line so that it propagates through the line. The delay line is correctly calibrated if the chosen reference transition (rising edge or falling edge) occurs at the input to the delay line just as the previous reference transition arrives at the delay line output. The process of calibrating the delay line involves monitoring the position of transitions propagating through the delay line with respect to the reference transition of the calibration clock and increasing or decreasing the number of selected control lines of the delay cells so that the propagating pulse is delayed exactly 360 degrees and the two transitions coincide in time.

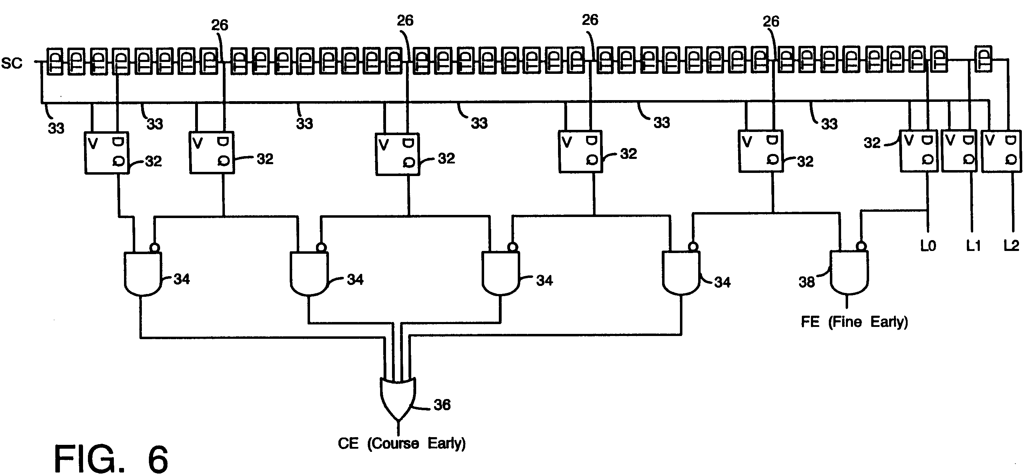

Fig. 6 shows a circuit for monitoring falling pulse edge positions of a transition propagation through the delay line relative to the transition edge of the clock input signal 33. Sample terminals 26 on the delay line are connected through D flip flops 32 to AND gates 34. The input from the oldest delay line tap (rightmost input terminal of the respective AND gate shown in Fig. 6) to the respective AND gate 34 is inverted in order to detect transitions that are rising. For the detection of falling edges, the inverted input would be placed on the left side to the AND gate. The output of all the NAND gates 34 are input to OR gate 36 for the coarse early signal (CE).

To begin the calibration process, all of the enabling switches are open so that the sample transition is initially in a section of the delay line which is close to the input terminal. Referring to Fig. 2 and 3, enabling switches 20 are then closed starting with switches in the region of s(0) thereby decreasing the delay and moving the transition closer to the signal output end of the delay line in the same time.

Fig. 6 also shows a circuit for applying a strategy for calibrating the delay line in which "coarse" adjustments of the delay are made initially in the "coarse early" section of the delay line at which stage the delay is not long enough, i.e. the transition is early, and is remote from the required delay. In the "coarse early" stage, calibration (opening of gate switches) is performed simultaneously on all of cells within groups of cells located among cells 1-41.

In fine adjust mode, the delay cells are calibrated in 8 ns groups. Within an 8 ns group of delay cells, any one inverting 0.5 ns delay cell may have one extra, or one less switch control line selected than the other members of the group. This allows each 8 ns delay group to be adjusted by the minimum delay increment of a 0.5 ns delay cell. The minimum delay for a 0.5 ns cell is on the order of 40-50 ps.

Smaller step adjustments of delay are made in the "fine early section" as the actual delay approaches the target delay which occurs when the transition is near the end of the delay line. Calibration is performed on one 0.5 ns Delay cell in each of the five 8 ns cell groups. In the "fine early" region, the transition location is advanced in 200-250 ps increments (i.e., 40 or 50 ps times 5) until the transition is determined to be located in cell 40.

In this condition, calibration continues in order to place the transition edge between cells 40 and 41, corresponding to the value of delay. This is the 360 degree phase transition where the transition edge of one pulse previously input to the delay line arrives at the output at the same time that the transition edge of the next pulse is being input to the delay line.

When the transition position is consistently captured near the output of delay cell 40, then, either a small adjustment or no adjustment is required. The outputs of delay cells 39, 40 and 41 can be used for gathering statistics as to where the average position is located. If the transition position is found more frequently between cells 40 and 41, then the propagation delay is decreased. If no edge is detected, then it is assumed that the propagation delay of the delay cells is too small and must be increased.

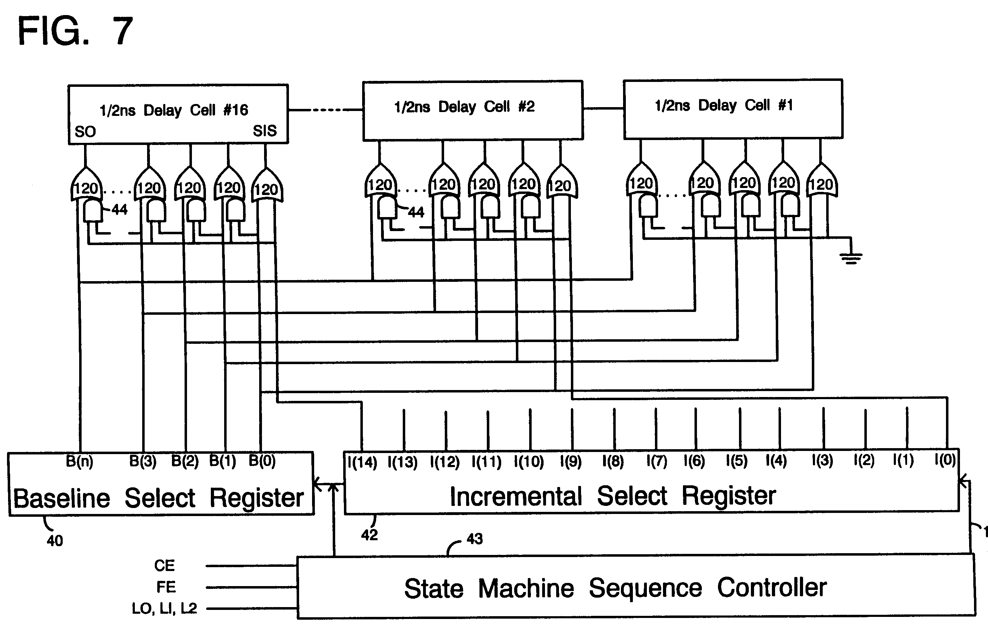

Fig. 7 shows a delay cell control line selection circuit in which each OR gate 120 output is connected to a switch in the delay cell corresponding to switch 20 in Fig. 2. The control circuit includes two registers, a baseline select register 40 (BSR) and an incremental select register 42 (ISR). Each bit B(n) of BSR 40 is connected via a plurality of control lines to an OR logic gate 20 belonging to an 8 ns cell group. Each control line is connected to its respective cell in a position that is common to all control line-cell connections of the group. Each bit of the ISR 42 is connected to all of the control lines of one, and only one, of the 0.5 ns delay cells in a given 8 ns delay group. A sequence state machine controller 43 runs the algorithm responsive to the decision points in the flow chart and increases and decreases the register values accordingly.

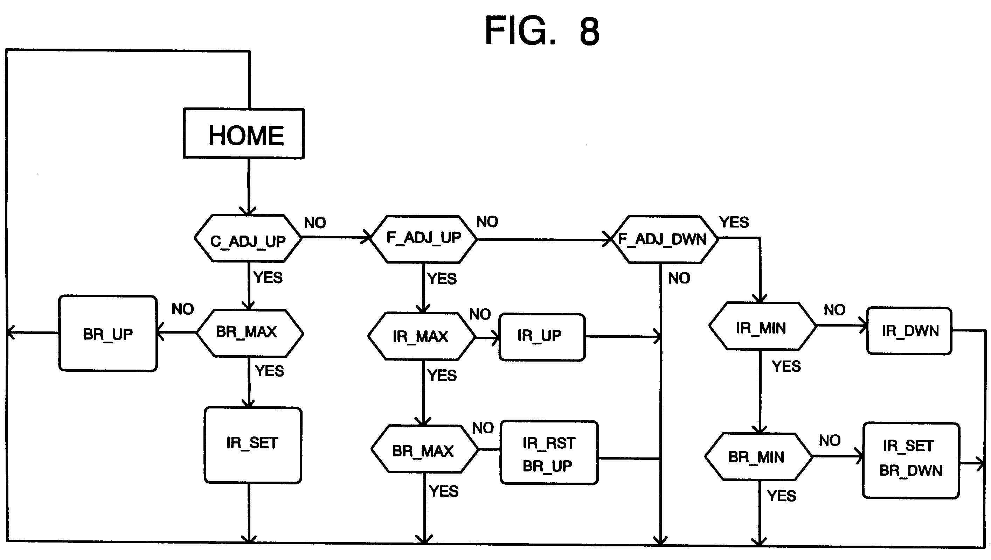

Fig. 8 is a flow chart of an algorithm illustrating the steps taken to increment the BSR 40 and ISR 42 (Fig. 7) responsive to the status signals from the "coarse early" and "fine early" edge detection circuit (Fig. 6).

Initially, both registers of Fig. 7 hold zeroes in all bit positions (HOME). The delay line (8 units x 0.5 ns/unit) is thus set to its intrinsic delay in which the propagation delay is set at its maximum setting. Coarse adjustment of the delay line is made by shifting a "1" into the BSR 40. This causes each of the 0.5 ns delay cells to be decreased by 40 ps to 50 ps resulting in a combined 40 ns delay line increase of 3.2 to 4.0 ns. Fine adjustment of the delay line is made by shifting a "1" into ISR 42. This causes one delay of one cell to be decreased by 40 ps to 50 ps resulting in a combined decrease of 200 ps to 300 ps for a 40 ns delay line. When the ISR 42 contains a "1" in every bit position, the next incremental delay increase causes the ISR 42 to be reset and a "1" to be shifted into the BSR 40 yielding the same delay line increase of 200 ps to 300 ps. To decrease the propagation delay of the 40 ns delay line, the previously described procedure is reversed.

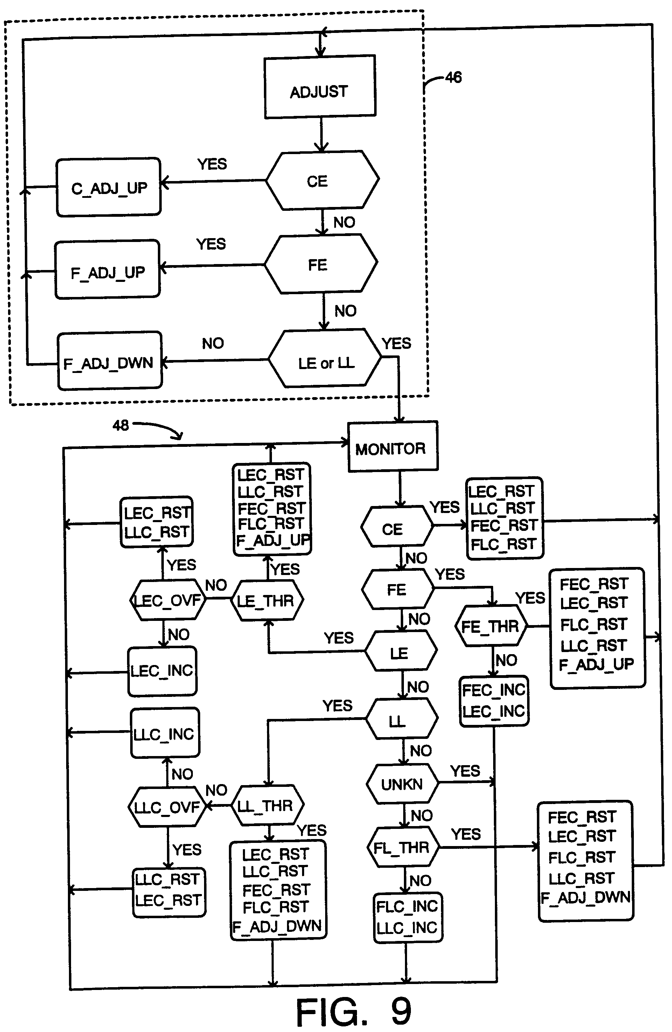

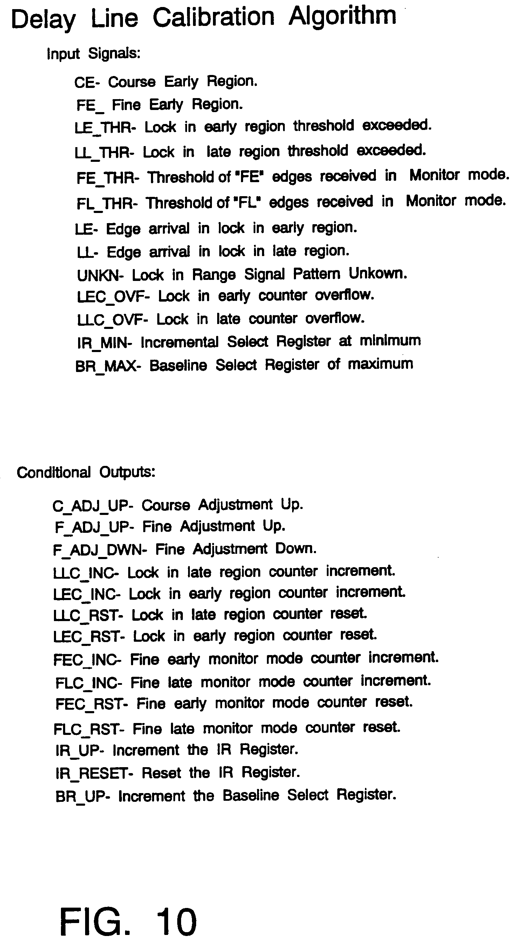

Fig. 9 is a flow chart of an algorithmic state machine which controls the process of incrementing and decrementing the BSR 40 and ISR 42. The algorithmic state machine monitors the "early" and "late" status of sampled edges from the delay line. The legend for the indicia shown in Fig. 9 is presented in Fig. 10.

The calibration algorithm of Fig. 9 has two states or modes of operation. The first mode is called the "adjust" mode and is shown within enclosure 46 in Fig. 9 Adjust mode 46 is entered whenever rising edges are detected in the "coarse early" or "fine early", or no lock-in-early (LE) and not lock-in-late (LL) regions. Its purpose is to rapidly adjust the delay cells so that sampled edges are moved to the region between delay cells 39 and 41 or the "lock-in" region. The state machine algorithm will cause a coarse or fine adjustment to be made in every calibration clock cycle in which a reference edge is detected outside of the lock-in region. When an edge arrival in lock-in-early (LE) or an edge arrival in lock-in-late (LL), the algorithm jumps to the Monitor mode.

The second, fine, control mode is called the "Monitor" mode (48 in fig. 9) and is entered when an edge is detected within the lock-in region. When the algorithm enters the "Monitor" mode, adjustments are based on the number of edges sampled between the cells 40 and 41, Fig. 6. If the difference exceeds a certain threshold value, a minimum adjustment is made to move the transition closer to 39. The algorithm also monitors the frequency with which edges occur outside the lock-in range and will reenter the adjust mode if a threshold is exceeded.

Fig. 5 shows an embodiment of the invention in which the cell calibrated delay line is used to generate a signal having a frequency that is a multiple of a base clock frequency. This is achieved by applying taps at intervals along the line and combining, sequential taps together with one inverted signal in NAND logic gates 27 and the output of the NANDS are combined in OR gate 27'. This NAND gate connection extracts a pulse at rising edge of each transition. For example, to create a 125 MHz signal from a 25 MHz signal using a delay line with forty 1 ns delay cells, the delay line is tapped at 4 ns intervals. The higher frequency signal can be used for data transmission and various receiver functions.

Modifications and variations of the method and circuits disclosed in the foregoing description may be made which are within the scope of the invention. For example, a third group of sample points in addition to the coarse and fine group may be selected as an intermediate calibrating range between coarse and fine. The delay line may not have sampling terminals except at the first and last cell so that calibration is accomplished by closing control switches until an edge transition appears at the output terminal coinciding with an edge from the input signal. Additional sampling points may be connected at other locations in the delay cell for special applications. With the above in view, my invention is not intended to be limited by the embodiments disclosed but the scope is to be determined by the claims.

## Claims

1. A delay line having a plurality of cells wherein each said cell comprises:
an input terminal and an output terminal;
a first PMOS/NMOS pair of transistors, each said transistor having source, drain and gate electrodes;
said drain electrode of said first NMOS transistor being connected to said drain electrode of said first PMOS transistor and to said cell output terminal;
said gate electrodes of said first PMOS and said first NMOS transistors being both connected to said cell input terminal ;
means for controlling and calibrating the propagation delay of each said cell, said means including a control terminal means adapted for connection to a control potential, said means also including a first portion and a second portion, said first portion being connected between said source electrode of said first PMOS transistor and a terminal adapted for connection to a positive bias potential, said second portion being connected between said source electrode of said first NMOS transistor and a terminal adapted for connection to ground potential; and
a plurality of said cells connected in series, said cell output terminal of each of said cells connected to a cell input terminal of a next one of said cells beginning with a first one of said cells having its input terminal adapted as a delay line input for connection to a signal source and a last one of said cells having its said cell output terminal adapted as a delay line output terminal.

2. A delay line comprising:
a plurality of cells, each said cell having a cell input and cell output terminal;
a CMOS transistor comprising a first PMOS/NMOS pair of transistors, said PMOS/NMOS transistors each having a gate, source and drain electrode wherein said drain electrode of said first NMOS transistor is connected to said drain electrode of said first PMOS transistor and to said cell output terminal, and wherein said gate electrode of said first PMOS transistor and said gate electrode of said first NMOS transistor are connected to said cell input terminal;
a plurality of second PMOS transistors, each having source, drain and gate electrodes;
said first PMOS transistor having its said source electrode connected to said drain electrodes of each of said second PMOS transistors;
a plurality of second NMOS transistors, each having source, drain and gate electrodes;
said first NMOS transistor having its said source electrode connected to said drain electrode of each of said second NMOS transistors;
each said drain electrode of each said second PMOS transistor being adapted for connection to a positive bias potential;
each said drain electrode of each said second NMOS transistor being adapted for connection to a ground potential;
a first control terminal adapted for receiving a first control voltage;
a second control terminal adapted for receiving a second control voltage; a means for switchably connecting said first and second control terminals to a first and second group of selected gate electrodes respectively of said second PMOS and said second NMOS transistors, said gate electrodes in each said first and second groups selected to provide a desired propagation delay on said delay line;
said plurality of cells being connected together with said cell output terminal of each one of said cells being connected to said cell input terminal of a next one of said cells beginning with a first one of said cells having its cell input terminal adapted as a delay line input for connection to a signal source and a last one of said cells having a cell output terminal adapted as a delay line output terminal.

3. A delay line as in claim 1 further comprising a plurality of sampling buffers, one buffer for a predetermined one of said cells respectively, each said buffer having a clocking terminal and a sampling terminal, said sampling terminal being connected to a said cell output terminal of a said predetermined one of said cells.

4. A delay line as in claim 2 which includes a plurality of sampling buffers, one buffer for a preselected one of said cells respectively, each said buffer having a clocking terminal and a sampling terminal, said sampling terminal being connected to said cell output terminal of said preselected cell.

5. A delay line as in claim 3 wherein said sampling buffer comprises:
a D flipflop having a flipflop input terminal, a clock terminal and a flipflop output terminal;
said clock terminal being connected to said delay line input terminal; and
said flipflop input terminal being said buffer sampling terminal whereby a signal is elicited on said flipflop output terminal corresponding to the signal at said sampling terminal clocked by said input to said delay line.

6. A delay line as in claim 4 wherein said buffer comprises:
a D flipflop having a flipflop input terminal, a clock terminal and a flipflop output terminal;
said clock terminal being connected to said delay line input terminal;
said flipflop input terminal being connected to one of said selected sampling terminals respectively whereby a signal is elicted on said flipflop output terminal responsive to a signal at said sampling terminal clocked by a delay line input signal.

7. A delay line as in claim 5 wherein means for detecting the position of said pulse edge includes:
a plurality of NAND gates, each said NAND gate having two input terminals;
one terminal of each NAND gate being connected to an input terminal of a neighboring NAND gate and to an output terminal of one of said D flipflops, respectively, such that when a transition edge of a propagated signal exists between two neighboring selected sampling points, a logical one will be elicited by said output terminal of said NAND gate having its inputs connected to said D flipflops having flipflop terminals connected to said neighboring sampling points on both sides of said transition of said pulse edge.

8. A delay line as in claim 6 wherein means for detecting position of said pulse edge includes:
a plurality of NAND gates, each said NAND gate having two input terminals;
one terminal of each NAND gate being connected to an input terminal of a neighboring NAND gate and to an output terminal of one of said D flipflops, respectively, such that when a transition edge of a propagated signal exists between two neighboring selected sampling points, a logical one signal will be elicited by said output terminal of said NAND gate having its inputs connected to said D flipflops having flipflop input terminals connected to said neighboring sampling points on both sides of said transition of said pulse edge.

9. The delay line of claim 2 wherein said means for switchably connecting includes, one FET switch member for each PMOS/NMOS transistor pair, each said FET switch member having a gate, source and drain, said source electrodes of said FET switch member being connected to said gate electrode of said respective second NMOS transistor;
a plurality of control inverters, one said control inverter for each said second PMOS/NMOS transistor pair, each control inverter having a first inverter terminal connected to said FET source and a second control inverter terminal connected to a gate electrode of said respective second PMOS transistor of said PMOS/NMOS transistor pair.

10. A delay line as in claim 9 further comprising an OR gate corresponding to each FET switch, said OR having one output and a pair of inputs;
each said gate of said FET switch member is coupled to said output of said OR gate.

11. The delay line of claim 8 wherein said means for switchably connecting includes a plurality of FET switch members, one FET switch member for each second PMOS/NMOS transistor pair, each said FET switch member having a gate terminal and a first and second channel terminals, said first channel terminal being connected to said gate electrode of said respective second NMOS transistor.

12. The delay line of claim 1 further comprising on algorithmic state machine connected to said means for controlling and calibrating said delay line; and wherein said first portion of said means for controlling comprising a plurality of parallel PMOS transistors

13. The delay line of claim 12 wherein said algorithmic state machine includes
a coarse and fine select register;
a sequence state machine controller; said sequence state machine controller coupled to said course and fine registers; and
said coarse and fine register, responsive to said sequence state machine controller, provides control signals to said means for controlling and calibrating said delay line.

14. A delay line as in claim 13 including
a plurality of OR gates, each said OR gate including two OR input terminals and an OR output terminal, said OR output terminal being coupled to a said gate electrode of a said PMOS transistor;
wherein said delay line further comprises,
each said coarse and fine register having a plurality of register output terminals, one register output terminal connected to one OR input terminal respectively for applying a digital code signal to said OR input terminals;
a plurality of sampling terminals connected between groups of said cells; and
a plurality of AND gates, each said AND gate having an output terminal and a plurality of AND input terminals, each AND input terminal being coupled to two of said sampling terminals such that a logic one signal is elicited on said AND output terminal when a transition edge from a propagated signal exists in the delay line between said sampling terminals.

15. A method for calibrating a delay line wherein said delay line includes a plurality of delay cells connected in series with an output terminal of one cell connected to the input terminal of a next cell beginning with a first cell having an input terminal where a signal is input to the delay line and ending with a last cell where said signal propagated along said delay line is output at an output terminal, each cell having a propagation time, said method including the steps:
(a) detecting a transition edge of a propagating signal at a sampling terminal between two cells relative to a transition edge of an initiating signal input to said delay line;
(b) adjusting said propagation time of selected ones of said delay cells as to move said transition edge of said propagating signal to said output terminal.

16. A method as in claim 15 wherein,
step (a), includes adjusting said propagation delay of said selected cells such that an edge transition of a propagating signal occurs at a sampling terminal distant from said output terminal; and
wherein said step (b) includes adjusting propagation delays simultaneously of groups of said cells such as to effect coarse movements of said transition toward said output terminal of said delay line, and then adjusting propagation delays of selected single cells such as to effect fine movement of said transition toward said output terminal of said delay line.

17. The method of claim 16 wherein both step (a) and step (b) are controlled by a sequence controller according to a algorithm.

18. The method of claim 17 wherein said algorithm attempts to maintain said transition in a target position between two said selected cells of said delay line and so long as said transition is within a predetermined number of said cells from its said target position, said algorithms will cause said sequence controller to remain in said fine movement mode of step (b).
